# EUROPEAN PATENT APPLICATION

(11) **EP 1 117 006 A1**
(43) Date of publication of application: **18.07.2001**
(21) Application number: 01300154.0
(22) Date of filing: 09.01.2001
(51) Int. Cl.: G03F 7/16, B32B 31/00, H05K 3/28

(54) **Photoresist having increased photospeed**

(30) Priority: 14.01.2000 US 483119
(71) Applicant: Shipley Company LLC, Marlborough, MA 01752 (US)
(72) Inventor: Shoemaker, Samuel W., Hudson, Massachusetts 01749 (US); Senk, David D., Mission Viejo, California 92692 (US); Hayes, Elmer P., Mission Viejo, California 92692 (US); Rath, James G., Orange, California 92869 (US); Alvarez, Alfredo Gustavo, Mesa, Arizona 85202 (US); Bridges, Kenneth A., Lincoln, Rhode Island 02865 (US)
(74) Representative: Buckley, Guy Julian

(57) **Abstract**

Methods of increasing the photospced of dry film primary photoresists without changing their chemical composition are disclosed. Also disclosed are methods for forming photoresist relief images.

## Description

### Background of the Invention

This invention relates generally to the field of photoresists. In particular, this invention relates to dry film photoresists having increased photospeed.

In a common method of preparing a printed circuit board, a primary imaging photoresist is applied as a dry film to a circuit board blank. The blank is typically a copper-clad epoxy board. A common dry film photoresist consists of a cover or support sheet, typically formed of a polyester, such as polyethyleneterephthalate ("PET"), a layer of photoimagcable composition, i.e. photoresist, and a removable protective sheet, such as polyethylene. The support sheet is of a thickness that gives the dry film shape, allowing the dry film to be rolled into a reel and subsequently be applied flat to the circuit board blank. The protective sheet is formed of a material, such as polyethylene, which is easily removed from the photoresist layer. To apply the resist layer to the circuit board blank, the protective sheet is removed, and the somewhat tacky resist layer is laminated to the copper-clad blank. An artwork is then laid over the support sheet, which remains on the photoresist layer, and the photoresist layer is exposed to actinic radiation through the artwork and through the support sheet: Following exposure, the support sheet is removed and the photoresist layer is developed to provide a relief image that permits selective processing of the printed circuit board substrate. Generally, as a final step, the remaining photoresist is stripped from the printed circuit board.

A photoresist can be either positive-acting or negative-acting. For most negative-acting photoresists, those coating layer portions that are exposed to activating radiation polymerize or cross-link in a reaction between a photoactive compound and polymerizable agents of the photoresist composition. Consequently, the exposed coating portions arc rendered less soluble in a developer solution than unexposed portions. For positive-acting photoresists, exposed portions are rendered more soluble in a developer solution while areas not exposed remain comparatively less developer soluble. In general, photoresist compositions include at least a resin binder component and a photoactive agent.

The photospeed of conventional dry film photoresists is too slow for such photoresists to work well with state-af-the-art imaging technology, such as laser imaging. For example, conventional dry film photoresists require approximately 40 mJ/cm² for exposure, which burns out a laser imager in a relatively short time. The photospeed of primary photoresists has typically been increased by chemically modifying the photoresist formulation. For example, U.S, Patent No. 5,252,427 (Bauer et al.) discloses positive photoresist compositions having increased photospeed wherein the photoresist contains a polymeric material having an acid number of at least 25. U.S. Patent No. 5,077,415 (Jasne et al.) discloses negative photoresist compositions having increased photospeed wherein the photoresist composition includes a modified dianhydride which has increased photospeed of the cross-linking reaction. However, such chemical modifications of the photoresist compositions result in increased cost and increased sensitivity to the manufacturing environment. Such chemically modified photoresists are also difficult to manufacture due to their extreme sensitivity to light, thus requiring special packaging and handling to avoid premature exposure.

U.S. Patent No. 4,127,436 (Friel) discloses the vacuum lamination of dry film photoresist-forming layers as soldermasks to ensure the soldermask conforms to the surface of printed wiring boards. Such vacuum lamination is disclosed to prevent bubbles between the soldermask layer and the printed wiring board substrate where solder could enter. Vacuum lamination was achieved by evacuating an area between the substrate and the soldermask layer and applying pressure to the soldermask, such as by venting to the atmosphere. This patent does not mention photospeed.

U.S. Patent No. 4,927,733 (Stout) discloses an improvement in vacuum laminating soldermasks to printed wiring boards by removing microvoids between the substrate and the soldermask. This is achieved by a combination of vacuum laminating the dry film soldermask to the substrate and exposing the soldermask coated printed wiring board to a pressurised fluid, such as compressed air. This patent does not mention the photospeed.

It is known that vacuum lamination of dry film photoresists used as soldermasks results in up to a 1-2 Stouffer 21 step increase in the photospeed of the soldermask. This increase in photospeed is lost within a short period of time, such as mostly eliminated within 15 to 30 minutes and completely eliminated within 8 hours. Typically, printed wiring boards containing such vacuum laminated soldermasks are held for a period of time, such as 30 minutes or greater, prior to exposure to allow the printed wiring boards to stabilize to room temperature. Such hold time is necessary to achieve consistent results.

In general, dry film photoresists used as soldermasks differ from dry film primary photoresists by the addition of a cross-linking agent to the soldermask to render the material not strippable and thus a permanent part of the printed wiring board. Also, dry film photoresists used as soldermasks are typically thicker than dry film primary photoresists. In general, a dry film soldermask has a 3 to 4 mil thick photoresist layer while a dry film primary photoresist has a photoresist layer that is 2 mil thick or less, and typically 1.2 to 2 mils thick.

There is thus a need for a method of increasing the photospeed of dry film primary photoresists without changing their chemical composition.

### Summary of the Invention

It has been surprisingly found that the photospeed of dry film primary photoresists can be significantly increased without changing their chemical compositions. Such dry film photoresists are particularly useful in state-of-the-art imaging technology, such as laser imaging.

In one aspect, the present invention provides a method for increasing the photospeed of dry film primary photoresists comprising the steps of removing a protective coating from a dry film primary photoresist, contacting the dry film primary photoresist with a substrate, and vacuum laminating the dry film primary photoresist to the substrate to form a laminated Structure.

In a second aspect, the present invention provides a method for forming a photoresist relief image comprising the steps of removing a protective coating from a dry film primary photoresist, contacting the dry film primary photoresist with a substrate, vacuum laminating the dry film primary photoresist to the substrate to form a laminated structure having a primary photoresist coating layer on the substrate, exposing the primary photoresist coating layer to patterned activating radiation; and developing the exposed primary photoresist coating layer to provide a photoresist relief image.

In a third aspect, the present invention provides a composition including one or more dry film primary photoreists disposed on a substrate, wherein the dry film primary photoresist is vacuum laminated to the substrate according to the process described above.

### Detailed Description of the Invention

As used throughout this specification, the following abbreviations shall have the following meanings, unless the context clearly indicates otherwise: ° C = degrees Centigrade; mJ = millijoulcs; ipm = inches per minute; cm = centimeter; min = minute; sec = second; mbar = millibar; UV = ultraviolet; and PWB = printed wiring board.

The terms "printed wiring board" and "printed circuit board" are used interchangeably throughout this specification. "Polymers" refers to both homopolymers and copolymers. The term "(meth)acrylate" refers to both acrylate and methacrylate. Likewise, the term "(meth)acrylic" refers to both acrylic and methacrylic. "Halide" refers to fluorine, chlorine, bromine, and iodine. The term "alkyl" includes linear, branched and cyclic alkyl. Likewise, the terms "alkenyl" and "alkynyl" include linear, branched and cyclic alkenyl and alkynyl, respectively.

All amounts are percent by weight and all ratios are by weight, unless otherwise noted. All numerical ranges are inclusive.

The present invention is directed to a method of increasing the photospeed of dry film primary photoresists including the steps of removing a protective coating from a dry film primary photoresist, contacting the photoresist with a substrate, and vacuum laminating the photoresist to the substrate to form a laminated structure. While the dry film photoresists may be either positive-acting or negative-acting, it is preferred that the photoresists of the present invention arc negative-acting.

Dry film primary photoresists typically contain one or more polymeric binders, one or more photomonomers and an initiator system. The polymeric binders typically have a molecular weight in the range of 20,000 to 150,000, although polymeric binders having molecular weights outside this range may successfully be employed.

Suitable polymeric binders useful in the present invention include, but are not limited to, those containing one or more of the following monomers: alkyl (meth)acrylate monomers, alkenyl (meth)acrylate monomers, alkynyl (meth)acrylate monomers, (meth)acrylic acid monomers, vinyl ester monomers, anhydride monomers, vinylhalide monomers, styrene and substituted styrene monomers, vinylidenchalide monomers, synthetic rubber monomers, epoxide monomers, amide monomers, cellulose esters, cellulose ethers, vinyl acetals, bis-phenol monomers, phosgene, formaldehyde and the like.

Typically, the alkyl (meth)acrylates useful in the present invention are (C₁-C₂₄) alkyl (meth)acrylates. Suitable alkyl (meth)acrylates include, but are not limited to, "low cut" alkyl (meth)acrylates, "mid cut" alkyl (meth)acrylates and "high cut" alkyl (meth)acrylates.

"Low cut" alkyl (meth)acrylates are typically those where the alkyl group contains from 1 to 6 carbon atoms. Suitable low cut alkyl (meth)acrylates include, but are not limited to: methyl methacrylate ("MMA"), methyl acrylate, ethyl acrylate, propyl methacrylate, butyl methacrylate ("BMA"), butyl acrylate ("BA"), isobutyl methacrylate ("IBMA"), hexyl methacrylate, cyclohexyl methacrylate, cyclohexyl acrylate and mixtures thereof.

"Mid cut" alkyl (meth)acrylates are typically those where the alkyl group contains from 7 to 15 carbon atoms. Suitable mid cut alkyl (meth)acrylates include, but are not limited to: 2-ethylhexyl acrylate ("EHA"), 2-ethylhexyl methacrylate, octyl methacrylate, decyl methacrylate, isodecyl methacrylate ("IDMA", based on branched (C₁₀)alkyl isomer mixture), undecyl methacrylate, dodecyl methacrylate (also known as lauryl methacrylate), tridecyl methacrylate, tetradecyl methacrylate (also known as myristyl methacrylate), pentadecyl methacrylate and mixtures thereof. Particularly useful mixtures include dodecyl-pentadecyl methacrylate ("DPMA"), a mixture of linear and branched isomers of dodecyl, tridecyl, tetradecyl and pentadecyl methacrylates; and lauryl-myristyl methacrylate ("LMA"),

"High cut" alkyl (meth)acrylates are typically those where the alkyl group contains from 16 to 24 carbon atoms. Suitable high cut alkyl (meth)acrylates include, but are not limited to: hexadecyl methacrylate, heptadecyl methacrylate, octadecyl methacrylate, nonadecyl methacrylate, cosyl methacrylate, eicosyl methacrylate and mixtures thereof. Particularly useful mixtures of high cut alkyl (meth)acrylates include, but are not limited to: cetyl-eicosyl methacrylate ("CEMA"), which is a mixture of hexadecyl, octadecyl, cosyl and eicosyl methacrylate; and cetyl-stcaryl methacrylate ("SMA"), which is a mixture of hexadecyl and octadecyl methacrylate.

The mid-cut and high-cut alkyl (meth)acrylate monomers described above are generally prepared by standard esterification procedures using technical grades of long chain aliphatic alcohols, and these commercially available alcohols arc mixtures of alcohols of varying chain lengths containing between 10 and 15 or 16 and 20 carbon atoms in the alkyl group. Examples of these alcohols are the various Ziegler catalyzed ALFOL alcohols from Vista Chemical company, i.e., ALFOL 1618 and ALFOL 1620, Ziegler catalyzed various NEODOL alcohols from Shell Chemical Company, i.e. NEODOL 25L, and naturally derived alcohols such as Proctor & Gamble's TA-1618 and CO-1270. Consequently, for the purposes of this invention, alkyl (meth)acrylate is intended to include not only the individual alkyl (meth)acrylate product named, but also to include mixtures of the alkyl (meth)acrylates with a predominant amount of the particular alkyl (meth)acrylate named.

The alkyl (meth)acrylate monomers useful in the present invention may be a single monomer or a mixture having different numbers of carbon atoms in the alkyl portion. Also, the (meth)acrylamide and alkyl (meth)acrylate monomers useful in the present invention may optionally be substituted. Suitable optionally substituted (meth)acrylamide and alkyl (meth)acrylate monomers include, but arc not limited to: hydroxy (C₂-C₆)alkyl (meth)acrylates, dialkylamino(C₂-C₆)-alkyl (meth)acrylates, dialkylamino(C₂-C₆)alkyl (meth)acrylamides.

Suitable polymeric binders include, but are not limited to: polymethyl methacrylate, polyethyl methacrylate, polyvinyl acetate, polyvinyl acetate/(meth)acrylate, hydrolyzed polyvinyl acetate, ethylene/vinyl acetate copolymers, polystyrene copolymers with maleic anhydride and esters, polyvinylidene chloride, vinylidene chloride/acrylonitrile copolymers, vinylidene chloride/methacrylate copolymers, vinylidene chloride/vinyl acetate copolymers, polyvinyl chloride, polyvinyl chloride/acetate, saturated and unsaturated polyurethanes, butadiene/acrylonitrile copolymers, acrylonitrile/butadiene/styrene copolymers, methacrylate/acrylonitrile/butadiene/styrcne copolymers, 2-chloro-butadiene-1,3 polymers, chlorinated rubber, styrenc/butadiene/styrene, styrene/isoprene/styrene block copolymers, high molecular weight polyethylene oxides of polyglycols having average molecular weights from about 4,000 to 1,000,000, epoxides containing acrylate or methacrylate groups, copolyesters such as those prepared from the reaction product of a polymethylene glycol of the formula HO(CH₂)ₙOH where n is a whole number 2 to 10, and (1) hexahydroterephthalic, sebacic and terephthalic acids, (2) terephthalic, isophthalic and sebacic acids, (3) terephthalic and sebacic acids, (4) terephthalic and isophthalic acids, and (5) mixtures of copolyesters prepared from said glycols and (i) terephthalic, isophthalic and sebacic acids and (ii) terephthalic, isophthalic, sebacic and adipic acids; nylons or polyamides such as N-methoxymethyl polyhexamethylene adipamide, cellulose acetate, cellulose acetate succinate, cellulose acetate butyrate, methyl cellulose, ethyl cellulose, benzyl cellulose, polycarbonates, polyvinyl butyral, polyvinyl formal, and polyformaldehydes.

For use with aqueous developers, the polymeric binder in the photoresist composition should contain sufficient acidic, i.e. carboxyl groups, or other groups to render the composition processible in aqueous developer. Useful aqueous-processible binders include those disclosed in U.S. Patent No. 3,458,311 and in U.S. Patent No. 4,273,857. Useful amphoteric polymeric binders which are aqueous processible include interpolymers derived from N-alkylacrylamidcs or methacrylamides, acidic film-forming comonomer and an alkyl or hydroxyalkyl acrylate such as those disclosed in U.S. Patent No. 4,293,635. In development the photosensitive layer will be removed in the portions which are not exposed to radiation but will be substantially unaffected during development by a liquid such as wholly aqueous solutions containing 1% sodium carbonate by weight. Illustratively a liquid or solution at a temperature of 30° to 35° C during a time period of two to three minutes will remove areas of the composition which have not been exposed to actinic radiation but will not remove exposed areas.

Suitable photomonomers which can be used as the sole photomonomer or in combination with others include, but arc not limited to: vinyl ethers, urethane (meth)acrylates, t-butyl acrylate, 1,5-pentanediol diacrylate, N,N-diethylaminoethyl acrylate, ethylene glycol diacrylate, 1,4-butanediol diacrylate, diethylenc glycol diacrylate, hexamethylene glycol diacrylate, 1,3-propanediol diacrylate, decamethylene glycol diacrylate, decamethylene glycol dimethacrylate, 1,4-cyclohexanediol diacrylate, 2,2-dimethylolpropane diacrylate, glycerol diacrylate, tripropylene glycol diacrylate, glycerol triacrylate, trimethylolpropane triacrylate, pentaerythritol triacrylate, polyoxyethylated trimethylolpropane triacrylate and trimethacrylate and similar compounds as disclosed in U.S. Patent No. 3,380,831, 2,2-di(p-hydroxyphenyl)propanc diacrylate, pentaerythritol tetraacrylate, 2,2-di-(p-hydroxyphenyl)-propane dimethacrylate, triethylene glycol diacrylate, polyoxyethyl-2,2-di-(p-hydroxyphenyl)-propane dimethacrylate, di-(3-methacryloxy-2-hydroxypropyl) ether of bisphenol-A, di-(2-methacryloxyethyl) ether of bisphenol-A, di-(3-acryloxy-2-hydroxypropyl) ether of bisphenol-A, di-(2-acryloxyethyl) ether of bisphenol-A, di-(3-methacryloxy-2-hydroxypropyl) ether of tetrachloro-bisphenol-A, di-(2-methacryl-oxyethyl) ether of tetrachloro-bisphenol-A, di-(3-methacryloxy-2-hydroxypropyl) ether of tetrabromobisphenol-A, di-(2-methacryloxyethyl) ether of tetrabromo-bisphenol-A, di-(3-methacryloxy-2-hydroxypropyl) ether of 1,4-butanediol, di-(3-methacryloxy-2-hydroxypropyl) ether of diphcnolic acid, triethylene glycol dimethacrylate, polyoxypropyltrimethylol propane triacrylate (462), ethylene glycol dimethacrylate, butylene glycol dimethacrylate, 1,3-propanediol dimethacrylate, 1,2,4-butanetriol trimethacrylate, 2,2,4-trimcthyl-1,3-pentanediol dimethacrylate, pentaerythritol trimethacrylate, 1-phcnyl ethylene-1,2-dimethacrylate, pentaerythritol tetramethacrylate, trimethylol propane trimethacrylate, 1,5-pentanediol dimethacrylate, diallyl fumarate, styrene, 1,4-benzenediol dimethacrylate, 1,4-diisopropenyl benzenc, and 1,3,5-triisopropenyl benzene.

A particularly useful class of photomonomers arc alkylene or polyalkylene glycol diacrylates prepared from an alkylene glycol of 2 to 15 carbons or a polyalkylene ether glycol of 1 to 10 ether linkages, and those disclosed in U.S. Patent No. 2,927,022, e.g., those having a plurality of addition polymerizable ethylenic linkages particularly when present as terminal linkages. Especially preferred are those wherein at least one and preferably most of such linkages arc conjugated with a double bonded carbon, including carbon double bonded to carbon and to such heteroatoms as nitrogen, oxygen and sulfur. Outstanding arc such materials wherein the ethylenically unsaturated groups, especially the vinylidene groups, arc conjugated with ester or amide structures.

Any initiator system that generates sufficient amounts of free radicals upon exposure to actinic radiation is suitable for use in the present invention. Suitable initiator systems include, but are not limited to, one or more of: substituted or unsubstitutcd polynuclear quinones which are compounds having two intracyclic carbon atoms in a conjugated carbocyclic ring system, such as 9,10-anthraquinone, l-chloroanthraquinone, 2-chloroanthraquinonc, 2-methylanthraquinone, 2-cthylanthraquinone, 2-tert-butylanthraquinone, octamcthylanthraquinonc, 1,4-naphthoquinone, 9,10-phenanthrenequinone, 1,2-benzanthraquinone, 2,3-benzanthraquinone, 2-methyl-1,4-naphthoquinone, 2,3-dichloronaphthoquinone, 1,4-dimcthylanthraquinone, 2,3-dimethylanthraquinone, 2-phenylanthraquinone, 2-3-diphenylanthraquinone, sodium salt of anthraquinone α-sulfonic acid, 3-chloro-2-methylanthraquinone, retenequinone, 7,8,9,10-tetrahydro-naphthacenequinone, 1,2,3,4-tetrahydrobenz(a)-anthracene-7,12-dione, benzophenones such as benzophenone, N,N,N',N'-tetraethyl-4,4'-diaminobenzophenone and N,N,N',N'-tetramethyl-4,4'-diaminobenzophenone, thioxanthones such as isopropyl thioxanthone, imidazoles such as 2,2-bis(o-chlorophcnyl)-4,4',5,5'-tetraphenyl bisimidazole, benzoate esters such as ethyl-4-dimethyl benzoate and 2-ethylhexyl-p-dimethylaminobenzoate, acridines such as 9-phenylacridine, amides and dihaloamides such as dibromomalonamide, and N-phenylglycine. Other suitable photoinitiators include, but are not limited to: vicinal ketaldonyl alcohols, such as benzoin, pivaloin, acyloin ethers, e.g., benzoin methyl and ethyl ethers; a-hydrocarbon-substituted aromatic acyloins, including α-methylbenzoin, α-allylbenzoin and α-phenylbenzoin.

Preferred initiator systems include one or more of: benzophenones, thioxanthones, imidazoles, benzoate esters, acridines, amides, and N-phenylglycine. Particularly preferred initiator systems include one or more of benzophenone, N,N,N',N'-tetraethyl-4,4'-diaminobenzophenone, N,N,N',N'-tetramethyl-4,4'-diaminobenzophenone, isopropyl thioxanthone, 2,2-bis(o-chlorophenyl)-4,4',5,5'-tetraphenyl bisimidazole, ethyl-4-dimethyl benzoate, 2-ethylhexyl-p-dimethylaminobenzoate, 9-phenylacridine, dibromomalonamide, and N-phenylglycine.

The initiator Systems arc typically present in the dry film primary photoresist compositions of the present invention in an amount in the range of about 0.01 to 10 percent by weight, based on the total weight of the photoresist composition. When ethyl-4-dimethyl benzoate is used, either alone or in combination, it is preferred that it is present in an amount of 5% by weight or less, and more preferably 2.5% by weight or less.

The dry film primary photoresists useful in the present invention may further contain one or more plasticizers, coating aids, dyes, pigments, and the like. Such dyes and pigments may be added to the dry film photoresist to increase the visibility of the relief image. Any colorant used should be transparent to the actinic radiation used to form the relief image.

Typically, the dry film photoresists of the present invention contain 10 to 90 percent by weight polymeric binder, 20 to 40 percent by weight photomonomer, and 0.01 to 10 percent by weight initiator system, all based on the total weight of the photoresist composition. It is preferred that the photoresists contain 40 to 70 percent by weight polymeric binder, 25 to 35 percent by weight photomonomer, and 4 to 8 percent by weight initiator system. When ethyl-4-dimethyl benzoate is used as the initiator system, either alone or in combination, it is preferred that it is present in an amount of 5% by weight or less, and more preferably 2.5% by weight or less.

In general, dry film photoresists contain a flexible, polymeric cover or support sheet and a protective coating or sheet. Such cover sheets may be any of a variety of materials, such as polyamides, polyolefins, polyesters, vinyl polymers and cellulose esters. It is preferred that the cover sheet includes polyethyleneterephthalate. Such cover sheets typically have a thickness of up to 0.008 inches, preferably 0.00025 to 0.008 inches, and more preferably 0.00025 to 0.002 inches, Protective coatings suitable for use with the dry film photoresists of the present invention may be any of a variety of materials, such as polyamides, polyolefins, polyesters, vinyl polymers and cellulose esters. It is preferred that the protective sheet is polyethylene. Typically, protective coatings have a thickness up to 0.008 inches, preferably 0.00025 to 0.008 inches, and more preferably 0.00025 to 0.002 inches.

The dry film primary photoresists useful in the present invention are generally commercially available, such as those marketed by Shipley Company, L.L.C, (Marlborough, MA) under the LAMINAR tradename.

In the process of the present invention, the protective coating is first removed from the dry film photoresist. The removal of such protective coatings is well known to those skilled in the art. The photoresist is then contacted with a substrate surface. Such contact may be achieved, for example, by positioning the photoresist adjacent to the substrate surface. The photoresist film is then vacuum laminated to the substrate surface. By "vacuum lamination" is meant that a photoresist film is laminated to a substrate surface under vacuum conditions, that is, under conditions of reduced pressure.

In the vacuum lamination process of the present invention, the substrate with the photoresist contacting its surface is placed in a chamber, such as a vacuum chamber, the chamber is evacuated and then the vacuum is released, The release of the vacuum has the advantage of aiding in the lamination of the photoresist to the substrate and is generally referred to as "slap down."

The process of the present invention may be performed with any vacuum that reduces the gas pressure in the chamber. It is preferred that the gas pressure is substantially reduced by the vacuum. Typically, the gas pressure in the chamber is reduced to below one bar, preferably 10 mbar or less, and more preferably 3 mbar or less.

Any vacuum laminating apparatus, such as those used for the vacuum lamination of soldermasks, may be successfully used in the methods of the present invention. Suitable vacuum laminators include those disclosed in EP 0 460 621 A (Eiichi), and U.S. Patent Nos. 4,127,436 (Friel) and 4,927,733 (Stout) herein incorporated by reference to the extent they teach the preparation and use of vacuum laminating equipment.

It will be appreciated by those skilled in the art that the vacuum laminator, and in particular the platen, may be heated to aid in Jamination of the photoresist to the substrate. Typically, platen temperatures in the range of about 20° to about 100° C may be used, preferably about 40° to about 90° C, and more preferably about 50° to about 75° C.

It was surprisingly found that vacuum lamination of the dry film primary photoresists of the present invention to substrates results in a substantial increase in the photospeed of the photoresist. For example, the photospeed may be increased by 8 Stouffer 21 steps or greater, as compared to conventional hot roll lamination techniques. It has also been surprisingly found that such increased photospeed rapidly decreases with time after vacuum lamination. Typically, any increase in photospeed is completely eliminated by the end of two hours after vacuum lamination. Thus, the vacuum laminated photoresists of the present invention must be exposed within two hours of vacuum lamination to the substrate, preferably within one hour, more preferably within 0.5 hours, and most preferably within 0.25 hours. It will be appreciated by those skilled in the art that the sooner the laminated photoresist is exposed, the faster will be the photospeed.

An advantage of the present invention is that the photoresists may be exposed immediately after vacuum lamination. Thus, the process of the present invention is particularly suited for use in automated lines where the photoresist is exposed within a very short time, such as less than 10 minutes, of vacuum lamination.

It will be appreciated that the vacuum in the vacuum laminator may be broken by any known means, including venting to the atmosphere or the use of compressed air. The laminated structure may then be removed from the chamber and exposed. While not wishing to be bound by theory, it is believed that once the laminated photoresist is exposed to such oxygen-containing sources, the photospeed starts to decrease. However, even after a few minutes exposure to such oxygen-containing environments, the photospeed is still greatly increased as compared to the photospeed after roll lamination techniques.

In another embodiment, the increased photospeed of the vacuum laminated photoresists of the present invention may maintained by using a cover sheet thicker than that used in conventional dry film primary photoresists. In general, conventional dry film primary photoresists contain a cover sheet having a thickness of less than 1mil. A cover sheet having a thickness in the range of about 1.1 mils and greater, such as up to 10 mils, preferably about 1.1 to about 8 mils, has the advantage of maintaining the increased photospeed of the vacuum laminated photoresists of the present invention, thus providing a longer time period for exposure of the photoresist. For example, a cover sheet having a thickness of about 7 mils shows only a 1 step reduction as compared to a 0.75 mil cover sheet which shows a 3 step reduction over the same time period, as measured on a Stouffer 21 stepper.

The vacuum lamination process of the present invention may be used to increase the photospeed of any dry film primary photoresist composition. Such vacuum laminated dry film primary photoresists arc useful in all applications where dry film primary photoresists arc typically used. For example, the compositions may be applied over silicon wafers or silicon wafers coated with silicon dioxide for the production of microprocessors and other integrated circuit components. Aluminum-aluminum oxide, gallium arsenide, ceramic, quartz, copper, glass and the like are also suitable employed as substrates for the photoresist compositions of the invention. It is preferred that the substrate is a printed wiring board.

In another embodiment, the present invention provides a composition including a substrate having a dry film primary photoresist layer, wherein the dry film primary photoresist layer is vacuum laminated to the substrate. Dry film primary photoresist layers that are vacuum laminated to substrates have significantly faster photospeeds than corresponding dry film photoresist layers that are hot roll laminated to substrates.

Once the photoresist composition is vacuum laminated to a substrate surface, it is imaged through a mask in a conventional manner. The exposure is sufficient to effectively activate the photoinitiator system of the photoresist to produce a patterned image in the resist coating layer, and more specifically, the exposure energy typically ranges from about 1 to 100 mJ/cm², dependent upon the exposure tool and the components of the photoresist composition. An advantage of the present invention is that because of the increased photospeeds of the vacuum laminated photoresists, the photoresists may be imaged at lower energy levels, such as below 30 mJ/cm², and preferably at 10 mJ/cm² or less.

The vacuum laminated photoresist compositions of the present invention are preferably activated by exposure to laser imaging. It will be appreciated by those skilled in the art that other actinic radiation, such as, but not limited to e-beam, x-ray, and UV light, may be used to expose the vacuum laminated photoresist compositions of the present invention.

Following exposure, the film layer is developed, i.e. un-exposed photoresist is removed. These unexposed non-polymerized materials arc solubilized in the developer solution and hence removed from the substrate. One skilled in the art will appreciate which development procedures should be used for a given system.

Specifically, in the case of aqueous processable negative acting photoresists, a 1% wt/wt solution of sodium carbonate is used to remove the unexposed or un-polymerized photoresist materials from the substrate surface. It is very important to achieve complete development, as not to inhibit future processing steps with residual un-polymerized material.

A further advantage of the present invention is that the image quality of vacuum laminated primary photoresists after development is the same as the image quality of hot rolled primary photoresists after development. Thus, the present invention may be advantageously used wherever hot roll lamination is used while requiring a lower energy exposure for the same image quality.

After development of the photoresist coating, the developed substrate may be selectively processed on those areas bared of resist, for example, by chemically etching or plating substrate areas bared of resist in accordance with procedures known in the art. After such processing, the resist may be removed from the processed substrate using any stripping procedures known in the art.

The following examples are intended to illustrate further various aspects of the present invention, but are not intended to limit the scope of the invention in any aspect. In the following examples, the terms "1/1" and "H/H" refer to printed wiring boards having a 1 ounce over 1 ounce or half-ounce over half-ounce copper cladding, respectively.

### Comparative Example 1

The conventional dry film primary photoresist imaging process using hot roll lamination is as follows:
A. Lamination:
   1. Heat rollers;
   2. Remove polyethylene protective sheet from the photoresist;
   3. Laminate photoresist to substrate with heat and pressure;
B. Image photoresist with actinic radiation, typically UV;
C. Develop off the unexposed areas.

### Example 1

The dry film primary photoresist imaging process of the present invention using vacuum lamination is as follows:
A. Lamination:
   1. Remove polyethylene protectíve sheet from the photoresist;
   2. Contact photoresist with substrate and place in vacuum chamber;
   3. Evacuate chamber;
   4. Slap photoresist on substrate by venting vacuum chamber;
B. Image photoresist with actinic radiation, such as UV or a laser;
C. Develop off the unexposed areas.

### Example 2

The compositions of the dry film primary photoresists used in the following examples are reported in the Table 1.

**Table 1**

| Photoresist | Polymetic Binder | Photomonomer | Initiator System | Other Additives |
|---|---|---|---|---|
| A | 40 g | 27.0 g | 7.1 g | 3.8 g |
| B | 40 g | 27.6 g | 1.3g | 1.4g |
| C | 40g | 24g | 3.2 g | 5.3g |
| D | 40g | 27.6g | 1.3g | 1.4g |

Photoresist A included an acrylate/styrene polymer and a methacrylate polymer as the polymeric binder and a mixture of benzophenones, a bisimidazole, and a benzoate as the initiator system. Both Photoresists B and D included the same (meth)acrylate/styrene polymer as the polymeric binder. Photoresist C also contained a (meth)acrylate/styrene polymer as the polymeric binder and benzophenones as the initiator system. The photomonomer in each photoresist was a (meth)acrylate cross-linker.

Other additives in the above photoresists included dye systems containing a background dye and a reactive dye, coating aids, antioxidants, adhesion promoters and the like.

### Example 3

Laminated substrates were prepared by vacuum laminating commercial dry film primary photoresist A, containing a polyethylene protective sheet, a 1.3 mil thick layer of photoresist A, and a PET cover sheet, to a 9 inch x 12 inch PWB having a 62 mil thick core and 1/1 copper cladding and to a 9 inch x 12 inch PWB having a 4 mil thick core and H/H copper cladding. The vacuum laminator platen was heated to 40° or 60° C. The cycle times varied and a 10 second slap down was used. The polyethylene protective sheet was removed from the photoresist prior to vacuum lamination. The samples were held for various times prior to exposure at 10 mJ/cm² and evaluated using either a Stouffer 21 or a Stouffer 41 Cu stepper. The results arc reported in Table 2.

Two comparative samples (Comp. A and B) were prepared by hot roll laminating the commercial dry film photoresist A to the same substrate. The comparative samples were exposed at 10 and 33 mJ/cm² and evaluated using a Stouffer 21 or Stouffer 41 Cu stepper. The results are reported in Table 2.

**Table 2**

| Sample | Cycle Time (see) | Platen Temp. (° C) | Core Thickness (mils) | Exposure (mJ/cm²) | 3 Min. Hold 21/41 Step | 15 Min. Hold 21/41 Step |
|---|---|---|---|---|---|---|
| 3-1 | 60 | 40 | 62 | 10 | Cu 8 / Cu 20 | Cu 7 / Cu 18 |
| 3-2 | 120 | 40 | 62 | 10 | Cu 9 / Cu 21 | Cu 7 / Cu 18 |
| 3-3 | 180 | 40 | 62 | 10 | Cu 8 / Cu 21 | Cu 7 / Cu 17 |
| 3-4 | 60 | 60 | 62 | 10 | Cu 7 / Cu 18 | Cu 7 / Cu 18 |
| 3-5 | 120 | 60 | 62 | 10 | Cu 8 / Cu 20 | Cu 7 / Cu 18 |
| 3-6 | 180 | 60 | 62 | 10 | Cu 8 / Cu 20 | Cu 7 / Cu 17 |
| 3-7 | 60 | 40 | 4 | 10 | Cu 8 / Cu 20 | Cu 7 / Cu 18 |
| 3-8 | 120 | 40 | 4 | 10 | Cu 9 / Cu 21 | Cu 8 / Cu 19 |
| 3-9 | 180 | 40 | 4 | 10 | Cu 8 / Cu 20 | Cu 7 / Cu 18 |
| 3-10 | 60 | 60 | 4 | 10 | Cu 8 / Cu 20 | Cu 7 / Cu 17 |
| 3-11 | 120 | 60 | 4 | 10 | Cu 8 / Cu 20 | Cu 7 / Cu 18 |
| 3-12 | 180 | 60 | 4 | 10 | Cu 8 / Cu 20 | Cu 7 / Cu 18 |
| Comp. A | -- | -- | 62 | 33 | Cu 8 / Cu 19 | Cu 8 / Cu 19 |
| Comp. B | -- | -- | 62 | 10 | Cu 5 / Cu 11 | Cu 5 / Cu 11 |

The above data clearly show an increase in photospeed of the vacuum laminated dry film primary photoresists as compared to those prepared by conventional hot roll lamination techniques. The data also show that variations in cycle time during vacuum lamination does not affect the photospeed of the photoresist.

### Example 4

Laminated substrates were prepared by vacuum laminating commercial dry film primary photoresist B, containing a polyethylene protective sheet, a 1.5 mil thick layer of photoresist B, and a PET cover sheet, to a 9 inch x 12 inch PWB having a 62 mil thick core and 1/1 copper cladding. The vacuum laminator platen was heated to 60° C. The cycle times varied and a 10 second slap down was used. The polyethylene protective sheet was removed from the photoresist prior to vacuum lamination. The samples were held for various times prior to exposure at 10 mJ/cm² and evaluated using either a Stouffer 21 or a Stouffer 41 Cu stepper. The results arc reported in Table 3.

Two comparative samples (Comp. C and D) were prepared by hot roll laminating the commercial dry film photoresist B to the same substrate. The comparative samples were exposed at 10 and 21 mJ/cm² and evaluated using a Stouffer 21 or Stouffer 41 Cu stepper. The results are reported in Table 3.

**Table 3**

| Sample | Cycle Time (sec) | Exposure (mJ/cm²) | 3 Min. Hold 21/41 Step | 15 Min. Hold 21/41 Step | 30 Min. Hold 21/41 Step |
|---|---|---|---|---|---|
| 4-1 | 60 | 10 | Cu 14 / Cu 30 | Cu 11 / Cu 30 | -- |
| 4-2 | 120 | 10 | Cu 14 / - | Cu 12 / Cu 30 | -- |
| 4-3 | 180 | 10 | Cu 14/ Cu 30 | - | Cu 10/ cu 27 |
| Comparative C | -- | 21 | Cu 8 / Cu 21 | Cu 8 / Cu 21 | Cu 8 / Cu 21 |
| Comparative D | -- | 10 | Cu 6 / Cu 14 | Cu 6 / Cu 14 | Cu 6 / Cu 14 |

The above data clearly show an increase in photospeed of the vacuum laminated dry film primary photoresists as compared to those prepared by conventional hot roll lamination techniques. The data also show that variations in cycle time during vacuum lamination does not affect the photospeed of the photoresist.

### Example 5

Laminated substrates were prepared by vacuum laminating commercial dry film primary photoresist C, containing a polyethylene protective sheet, a 1.5 mil thick layer of photoresist C, and a PET cover sheet, to a 9 inch x 12 inch PWB having a 62 mil thick core and 1/1 copper cladding. The vacuum laminator platen was heated to 60° C. The cycle times varied and a 10 second slap down was used. The polyethylene protective sheet was removed from the photoresist prior to vacuum lamination. The samples were held for various times prior to exposure at 10 mJ/cm² and evaluated using either a Stouffer 21 or a Stouffer 41 Cu stepper. The results are reported in Table 4.

Two comparative samples (Comp. E and F) were prepared by hot roll laminating the commercial dry film photoresist C to the same substrate. The comparative samples were exposed at 10 and 56 mJ/cm² and evaluated using a Stouffer 21 or Stouffer 41 Cu stepper. The results are reported in Table 4.

**Table 4**

| Sample | Cycle Time (sec) | Exposure (mJ/cm²) | 3 Min. Hold 21 / 41 Step | 15 Min. Hold 21 / 41 Step | 30 Min. Hold 21/41 Step |
|---|---|---|---|---|---|
| 5-1 | 60 | 10 | Cu 11 / Cu 29 | Cu 9 / Cu 24 | - |
| 5-2 | 120 | 10 | Cu 12 / Cu 30 | -- | Cu 9 / Cu 22 |
| 5-3 | 180 | 10 | Cu 12 / Cu 26 | Cu 10 / Cu 26 | -- |
| | | | | | |
| Comparative E | - | 56 | Cu 10 / Cu 25 | Cu 10 / Cu 25 | Cu 10 / Cu 25 |
| Comparative F | -- | 10 | Cu 4 / Cu 10 | Cu 4 / Cu 10 | Cu 4 / Cu 10 |

The above data clearly show an increase in photospeed of the vacuum laminated dry film primary photoresists as compared to those prepared by conventional hot roll lamination techniques. The data also show that variations in cycle time during vacuum lamination does not affect the photospeed of the photoresist,

### Example 6

Laminated substrates were prepared by vacuum laminating commercial dry film primary photoresist D, containing a polyethylene protective sheet, a 1.5 mil thick layer of photoresist D, and a PET cover sheet, to a 9 inch x 12 inch PWB having a 62 mil thick core and 1/1 copper cladding using a 724 Vacuum Laminator. The vacuum laminator platen was heated to 70° C. The cycle time for each sample was 60 seconds and a 10 second slap down was used. The polyethylene protective sheet was removed from the photoresist prior to vacuum lamination. The samples were held for various times prior to exposure at 32-33 mJ/cm² and evaluated using either a Stouffer 21 or a Stouffer 41 Cu stepper. The results are reported in Table 5.

A comparative sample (Comp. G) was prepared by hot roll laminating the commercial dry film photoresist D to the same substrate using a Model 300 hot roll laminator with a 245° F roll temperature and a speed of 2 fpm (feet per minute). The comparative sample was exposed at 32-33 mJ/cm² and evaluated using a Stouffer 21 or Stouffer 41 Cu stepper. The results are reported in Table 5.

| | | | | | |
|---|---|---|---|---|---|
| Table 5 | | | | | |
| Sample | 3 Min. Hold 21 / 41 Step | 15 Min. Hold 21 / 41 Step | 30 Min. Hold 21 / 41 Step | 45 Min. Hold 21 / 41 Step | 60 Min. Hold 21 / 41 Step |
| 6-1 | Cu 17/Cu 40 | Cu 14 / Cu 37 | Cu 12 / Cu 33 | Cu 12 / Cu 31 | Cu 11 / Cu 29 |
| | | | | | |
| Comparative G | Cu 9 / Cu 24 | Cu 9 / Cu 24 | Cu 9 / Cu 24 | Cu 9 / Cu 24 | Cu 9 / Cu 24 |

The above data clearly show an increase in photospeed of the vacuum laminated dry film primary photoresists as compared to those prepared by conventional hot roll lamination techniques.

### Example 7

Laminated substrates were prepared according to the procedure of Example 6. The substrate was held for 30 minutes prior to exposure using an OTIBEAM 7120. The laminated substrates were exposed at various levels. Comparative H was prepared according to the procedure of Comparative G in Example 6. Comparative H was held for 30 minutes prior to exposure at 32 mJ/cm² using an OTIBEAM 7120. The data are reported in Table 6.

**Table 6**

| Exposure mJ/cm² | Invention 21 Step | Invention 41 Step | Comparative H 21 Step | Comparative H 41 Step |
|---|---|---|---|---|
| 31 | 13 | - | | |
| 17 | 10 | 27 | | |
| 12 | 9 | 22 | | |
| 9 | 8 | 20 | | |
| 6 | 7 | 18 | | |
| 2 | 5 | 12 | | |
| 32 | | | 9 | 24 |

The above data clearly show that vacuum laminated dry film primary photoresists provide an equivalent copper step to hot roll laminated photoresists, but do so at a higher photospeed.

### Example 8

The samples from Example 7, including Comparative H, were examined using scanning electron microscopy after exposure. No discernible difference was observed between the vacuum laminated substrates and the hot roll laminated comparative sample, Thus, the vacuum lamination of dry film primary photoresists to substrates provided images equal to those obtained from hot roll laminated photoresists.

### Example 9

Sample 9-1 was a commercial dry film primary photoresist containing a 0.75 mil

PET support sheet, 1.5 mil photoresist B layer and a polyethylene protective sheet. Sample 9-2 was a dry film primary photoresist containing a 7 mil PET support sheet, 1.5 mil photoresist B layer and a polyethylene protective sheet.

Both samples were vacuum laminated to a substrate and held for various times prior to exposure. The samples were exposed at 10 mJ/cm² and evaluated using a Stouffer 21 Cu stepper. The results are reported in Table 7.

| | | |
|---|---|---|
| Table 7 | | |
| Hold Time (min) | Sample 9-1 | Sample 9-2 |
| 3 | Cu 13 | Cu 11 |
| 5 | Cu 12 | Cu 11 |
| 15 | Cu 10 | Cu 10 |
| 30 | Cu 9 | Cu 9 |

From the above data it can be clearly seen that Sample 9-2, having a thick support sheet, showed a much lower loss of photospeed during the first 15 minutes of hold times, as compared to Sample 9-1, which had a thin (conventional) support sheet.

### Example 10

Samples of a dry film photoresist containing a PET support sheet of varying thicknesses, 1.5 mil photoresist C layer and a polyethylene support sheet were prepared. The cover sheet in Sample 10-1 had a thickness of 0.75 mil (conventional). The cover sheet thicknesses in Samples 10-2 and 10-3 were 1.42 mil and 7.0 mil, respectively.

All samples were vacuum laminated to substrates and held for various times prior to exposure. The samples were exposed at 10 mJ/cm² and evaluated using a Stouffer 21 stepper. The results are reported in Table 8.

**Table 8**

| Hold Time (min) | Sample 10-1 | Sample 10-2 | Samplc 10-3 |
|---|---|---|---|
| 3 | Cu 10 | Cu 11 | Cu 9 |
| 5 | Cu 9 | Cu 11 | Cu 9 |
| 10 | Cu 9 | Cu 10 | Cu 8 |
| 15 | Cu 8 | Cu 10 | Cu 8 |
| 30 | Cu 6 | Cu 9 | Cu 8 |

From the above data it can be clearly seen that the samples having thicker support sheets, i.c. samples 10-2 and 10-3, showed only a 2 step and I step difference, respectively, after 30 minutes hold time. In comparison, Sample 10-1, which had a thin (conventional) support sheet, showed a 4 step difference after 30 minutes holed time.

### Comparative Example 2

The procedure of Example 10 was repeated except that each photoresist was hot roll laminated to the substrate. Each sample was exposed at 10 mJ/cm² and produced a step of copper 4 on a Stouffer 21 stepper, regardless of hold time.

## Claims

1. A method for increasing the photospeed of dry film primary photoresists comprising the steps of removing a protective coating from a dry film primary photoresist, contacting the dry film primary photoresist with a substrate, and vacuum laminating the dry film primary photoresist to the substrate to form a laminated structure.

2. The method of claim 1 wherein the substrate is a printed wiring board.

3. The method of claim 1 wherein the dry film primary photoresist comprises an initiator system comprising one or more of benzophenones, thioxanthones, imidazoles, benzoate esters, acridines, amides, or N-phenylglycine.

4. The method of claim 3 wherein the initiator system comprises one or more of benzophenone, N,N,N',N'-tetraethyl-4,4'-diaminobenzophenone, N,N,N',N'-tetramethyl-4,4'-diaminobenzophcnone, isopropyl thioxanthone, 2,2-bis(o-chlorophenyl)-4,4',5,5'-tetraphenyl bisimidazole, cthyl-4-dimethyl bcnzoate, 2-ethylhexyl-p-dimcthylaminobenzoate, 9-phenylacridine, or dibromomalonamide.

5. The method of claim 1 further including the step of storing the laminated structure under oxygen-free conditions.

6. The method of claim 1 wherein the dry film primary photoresist comprises 10 to 90 percent by weight polymeric binder, 20 to 40 percent by weight photomonomer, and 0.01 to 10 percent by weight initiator system, all based on the total weight of the photoresist composition.

7. The method of claim 6 wherein the dry film primary photoresist comprises 40 to 70 percent by weight polymeric binder, 25 to 35 percent by weight photomonomer, and 4 to 8 percent by weight initiator system,

8. A composition comprising one or more dry film primary photoresists disposed on a substrate, wherein the dry film primary photoresist is vacuum laminated to the substrate according to the process of claim 1.

9. A method for forming a photoresist relief image comprising the steps of removing a protective coating from a dry film primary photoresist, contacting the dry film primary photoresist with a substrate, vacuum laminating the dry film primary photoresist to the substrate to form a laminated structure having a primary photoresist coating layer on the substrate, exposing the primary photoresist coating layer to patterned activating radiation; and developing the exposed primary photoresist coating layer to provide a photoresist relief image.

10. The method of claim 9 wherein the primary photoresist layer is exposed by laser imaging.

11. The method of claim 9 further including the step of holding the laminated structure under oxygen-free conditions prior to exposure.

12. The method of claim 9 wherein the dry film primary photoresist comprises 10 to 90 percent by weight polymeric binder, 20 to 40 percent by weight photomonomer, and 0.01 to 10 percent by weight initiator system, all based on the total weight of the photoresist composition.

13. , The method of claim 12 wherein the dry film primary photoresist comprises 40 to 70 percent by weight polymeric binder, 25 to 35 percent by weight photomonomer, and 4 to 8 percent by weight initiator system.

14. The method of claim 9 wherein the substrate is a printed wiring board.

15. The method of claim 9 wherein the dry film primary photoresist comprises an initiator system comprising one or more of benzophenones, thioxanthones, imidazoles, benzoate esters, acridines, amides, or N-phenylglycine.

16. The method of claim 15 wherein the initiator system comprises one or more of benzophenone, N,N,N',N'-tetraethyl-4,4'-diarninobenzophenone, N,N,N',N'-tetramethyl-4,4'-diaminobenzophenone, isopropyl thioxanthone, 2,2-bis(o-chlorophenyl)-4,4',5,5'-tetraphenyl bisimidazole, ethyl-4-dimethyl benzoate, 2-ethylhexyl-p-dimethylaminobenzoate, 9-phcnylacridine, or dibromomalonamide.
